# EUROPÄISCHE PATENTSCHRIFT

(11) **EP 1 609 594 B1**
(45) Veröffentlichungstag und Bekanntmachung des Hinweises auf die Patenterteilung: **07.01.2009**
(21) Anmeldenummer: 05104817.1
(22) Anmeldetag: 02.06.2005
(51) Int. Cl.: B32B 27/12, B32B 15/08, H05K 9/00, B27N 3/04

(54) **Mehrschichtplatte**
Multilayered panel
Panneau multicouche

(30) Priorität: 23.06.2004 EP 04102900
(43) Veröffentlichungstag der Anmeldung: 28.12.2005
(73) Patentinhaber: Grossegger, Chrysant, 9500 Villach (AT)
(72) Erfinder: Grossegger, Chrysant, 9500 Villach (AT)
(74) Vertreter: Kontrus, Gerhard

(56) Entgegenhaltungen:
- DATABASE WPI Section Ch, Week 200550 Derwent Publications Ltd., London, GB; Class A93, AN 1998-188123 XP002347765 & JP 01 044326 A (AICA KOGYO CO LTD) 17. Februar 1998 (1998-02-17) & JP 01 004436 A 9. Januar 1989 (1989-01-09)
- DATABASE WPI Section Ch, Week 199849 Derwent Publications Ltd., London, GB; Class F03, AN 1998-577413 XP002347766 & JP 10 259641 A (ICHINOMIYA SENBUTSU KK) 29. September 1998 (1998-09-29)
- PATENT ABSTRACTS OF JAPAN Bd. 011, Nr. 131 (M-584), 24. April 1987 (1987-04-24) & JP 61 273902 A (HARADA SANGYO:KK), 4. Dezember 1986 (1986-12-04)

## Beschreibung

Die Erfindung betrifft eine Mehrschichtplatte mit mindestens einer Holz enthaltenden Schicht.

Untersuchungen der elektrischen Wechselfelder und der elektromagnetischen Wellen (Strahlenbelastung) in Wohnungen und Gebäuden zeigen verschiedene Probleme. Viele gesundheitliche Beschwerden durch Elektrosmog sind auf nieder- u. hochfrequente Strahlenbelastungen wie z.B. E-Installationen u. Geräte, durch Mobilfunk und Schnurlos-Telefone (insbesondere DECT-Schnurlos-Telefone) zurückzuführen. Abschirmmaßnahmen in bestehenden Wohnungen und Gebäuden waren bisher technisch schwierig, kostenaufwendig und erfüllten oft nicht die Erwartungen. Die meisten Abschirmmaterialien erreichen nur eine geringe Dämpfung und sind z.B. nicht geeignet, die biologisch hochwirksame gepulste Mobilfunkstrahlung ausreichend abzuschirmen.

Diese Mobilfunkstrahlen resultieren einerseits aus dem Netz der Mobiltelefone und andererseits aus Schnurlostelefonen, vor allem deren Basisstationen.
JP10-044326A2 beschreibt eine Mehrschichtplatte mit mindestens einer Holz enthaltenden Schicht, wobei mindestens eine Schicht aus einem elektromagnetische Wellen abschirmendem Material besteht das zwischen zwei Schichten aus Holz eingebracht ist wobei das elektromagnetische Wellen abschirmende Material eine die elektrische Leitfähigkeit erhöhende Substanz enthält und zwar Kohlefasern. Metallfasern sind nicht erwähnt.

Die Aufgabe der Erfindung besteht darin ein Abschirmmaterial zu Verfügung zu stellen, dass kostengünstig herstellbar ist und gleichzeitig eine signifikante Abschirmwirkung im Bereich niederfrequenter Felder u. hochfrequenter elektromagnetischer Wellen bringt. Die Abschirmwirkung wird in dB (Dezibel) gemessen. Eine signifikante Abschirmwirkung im hochfrequenten Bereich ist eine Abschirmung (Transmissionsdämpfung) von über 20 dB (= 99%) im Frequenzbereich der elektromagnetischen Wellen von 100 kHz bis 20 GHz bzw. im niederfrequenten Frequenzbereich (geerdet)10 bis 100Hz.

Erfindungsgemäß wird die Aufgabe dadurch gelöst, dass Mehrschichtplatte zu Verfügung gestellt wird (1) mit mindestens einer Holz enthaltenden Schicht (2) wobei mindestens eine Schicht aus einem elektromagnetische Wellen abschirmendem Flächengebilde (3) besteht, und das elektromagnetische Wellen abschirmende Flächengebilde zwischen zwei Schichten aus Holz eingebracht ist, wobei das elektromagnetische Wellen abschirmende Flächengebilde ein gewebtes oder ungewebtes textiles Flächengebilde ist, das eine die elektrische Leitfähigkeit erhöhende Substanz enthält dadurch gekennzeichnet, dass das textile Flächengebilde Metallfassern als die elektrische Leitfähigkeit erhöhende Substanz und Polymerfasern enthält.

Die mindestens eine Holz enthaltenden Schicht kann als Massivholz, Sperrholz, Holzfaserplatte, Spanplatte in nicht beschichteter, in furnierter od. folierter Ausführung oder Holzwolle bestehen. Vorteil der Verwendung von Holz ist die Verwendung nachwachsender Rohstoffe, aber auch die Tatsache, dass Holz insbesondere als Massivholz eine optisch ansprechende Oberfläche liefert. Als elektromagnetische Wellen werden Wellen aus dem Frequenzbereich der, Radio-, Röntgen- oder Radarwellen verstanden, wobei insbesondere Funkwellen durch das abschirmende Flächengebilde abgeschirmt werden können. Die erfindungsgemäße Mehrschichtplatte ermöglicht es einen Werkstoff der Holz enthält zu Verfügung zu stellen der obendrein noch eine abschirmende Wirkung hat.

Da das elektromagnetische Wellen abschirmende Flächengebilde zwischen zwei Schichten aus Holz eingebracht wird kann die so erhaltene Mehrschichtplatte wie eine übliche Holzplatte als Möbelbrett zu z.B. Wand-Deckenverkleidungsplatten, Fußboden, Betten und Schränken weiterverarbeitet werden.

Es kann aber auch das elektromagnetische Wellen abschirmende Flächengebilde als Gegenzugschicht aufgebracht werden.

Das elektromagnetische Wellen abschirmende Flächengebilde ist ein gewebtes textiles Flächengebilde bzw. Gewebe oder ungewebtes textiles Flächengebilde bzw. Vlies, das eine die elektrische Leitfähigkeit erhöhende Substanz enthält.

Dadurch soll die Leitfähigkeit des textilen Flächengebildes bei einer Breite von 10 cm auf 1 m Länge auf unter 1000 Ohm (vorzugsweise unter 10 Ohm) gesenkt werden.

Das textile Flächengebilde enthält elektrisch leitfähige Fasern als die elektrische Leitfähigkeit erhöhende Substanz, die den Vorteil bringen dass leitfähige Fasern eine bessere Abschirmwirkung bringen als z.B. leitfähiges Pulver (z.B. Russ, Eisenfeilspäne).

Das textile Flächengebilde enthält Polymerfasern vorteilhafter Weise aus der Gruppe der Polyamidfasern und Polyesterfasern.

Bei Polymerfasern ist es möglich, dass diese selbst die elektrische Leitfähigkeit erhöhende Substanz enthalten.

Die die elektrische Leitfähigkeit erhöhende Substanz liegt in Form von Metallfasern vor.

Vorteilhaft sind Metallfasern z.B. aus der Gruppe Stahlfasern, Edelstahlfasern, Aluminiumfasern. Die elektrisch leitfähigen Fasern können mit anderen Fasern gemischt werden, wobei dieses Fasergemisch anschließend zu einem Garn gesponnen und gewebt oder auch zu einem Vlies gelegt werden kann. Die Fasern können aber auch in endloser Form mit anderen Fasern zu einem Garn gesponnen werden.

Für eine gute Abschirmwirkung ist es von Vorteil wenn die leitfähigen Fasern eine Länge von mindestens 2 cm, vorzugsweise 10cm, haben.

Vorteilhafterweise ist der Anteil der elektrisch leitfähigen Fasern an der Masse des elektromagnetische Wellen abschirmenden Flächengebildes mehr als 5%, insbesondere mehr als 10%.

Für eine gute Abschirmung auch im niederfrequenten Bereich ist es von Vorteil einen elektrischen Anschluss (z.B. Lasche) an der Mehrschichtplatte vorzusehen, über den das abschirmende Flächengebilde geerdet werden kann.

Alternativ kann elektrische Leitfähigkeit erhöhende Substanz aus Pulvern wie z.B. Russ oder Salzen (z.B. der Gruppe der Edelmetallhalogenide (z.B. Silberchlorid, Silberbromid)) gewählt werden. Dies ist von Vorteil wenn das elektromagnetische Wellen abschirmende Flächengebilde durch aufbringen eine Kunstharzschicht (Lackschicht) gebildet wird.

Ein weiterer Aspekt der Erfindung ist ein Möbelstück, das zu mindestens zum Teil aus einer erfindungsgemäßen Mehrschichtplatte entsteht.

Bei diesem Möbelstück kann es sich z.B. um einen Behälter zum Aufbewahren eines Telefons handeln. Es hat sich nämlich gezeigt, dass mit so einem Behälter insbesondere Schnurlostelefone oder die dazu gehörigen Basisstationen wirkungsvoll abgeschirmt werden können ohne diese dabei wesentlich in ihrer Funktion zu beeinträchtigen.

Auch kann es sich bei dem Möbelstück um ein Bett handelt. Dadurch so ein Bett können wenn die darin enthaltenen Mehrschichtplatten geerdet sind besonders gut neiderfrequente elektrische Wechselfelder abgeschirmt werden. Vorteilhafter Weise werden alle erfindungsgemäßen Mehrschichtplatten eine Bettkonstruktion miteinander elektrisch verbunden.

Weitere Einzelheiten ergeben sich aus den Zeichnungen und ihrer Beschreibung.

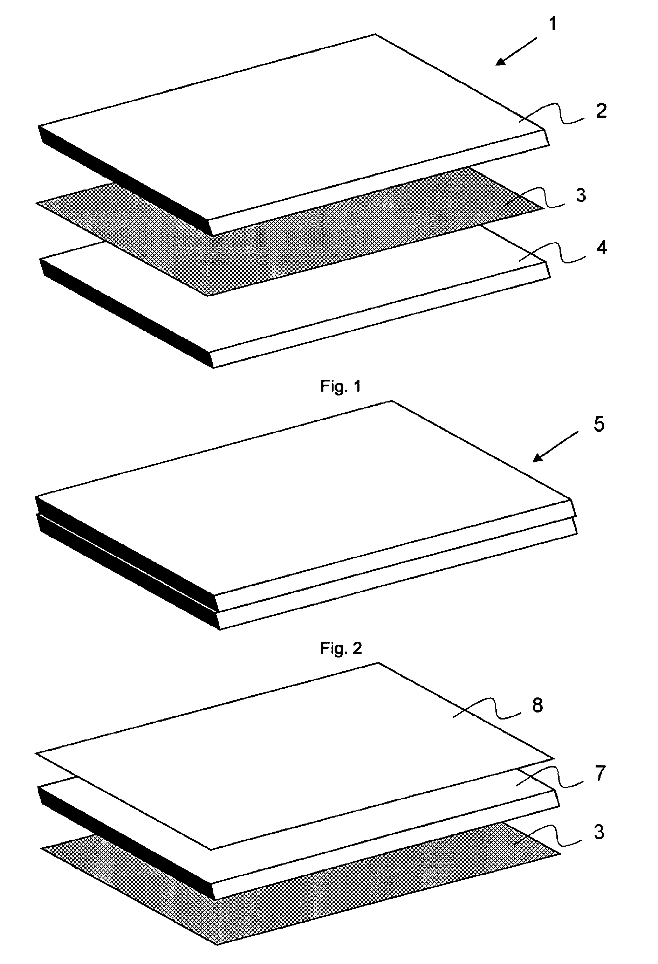

Fig. 1 zeigt schematisch eine Explosionszeichnung einer Mehrschichtplatte 1 mit einer ersten Holzschicht 2, einer zweiten Holzschicht 4 und einem dazwischen eingebrachten elektromagnetische Wellen abschirmenden Gewebe 3. Das Gewebe besteht aus ca. 80 gew.-% aus Polyesterfasern und ca. 20 gew.-% aus Edelstahlfasern. Das zur Herstellung des Gewebes verwendete Garn hat eine Dicke von ca. 20 Tex. Die Verwendung von wesentlich dünneren Geweben ist möglich, da dem Gewebe keine Festigkeitsaufgabe zukommt. Solche Gewebe können als Tücher zur Vermeidung elektrostatischer Aufladung (Antistatiktücher) im Handel erworben werden, oder auch als Stoff zur Abschirmung gegen elektromagnetische Felder.

Die Verbindung des Gewebes mit den Platten erfolgt durch hohen Druck (ca. 3 kg/cm²), wobei das Verbindungsmittel (Bindemittel) ein Phenolharz, ein Melamin-Formaldehydharz oder Kalt-( PVAC Leime) oder Heißleime (Harnstoffleime)sein können. Das Gewebe wird im Bindemittel getränkt und mit einer herkömmlichen Plattenpresse zwischen den Holzplatten eingepresst. Es kann auch sinnvoll sein beide Seiten des Gewebes mit Bindemittel zu bestreichen oder die Platten mit Bindemittel zu bestreichen.

Fig. 2 zeigt die erfindungsgemäße Mehrschichtplatte 5 in fertig gepresster Form.

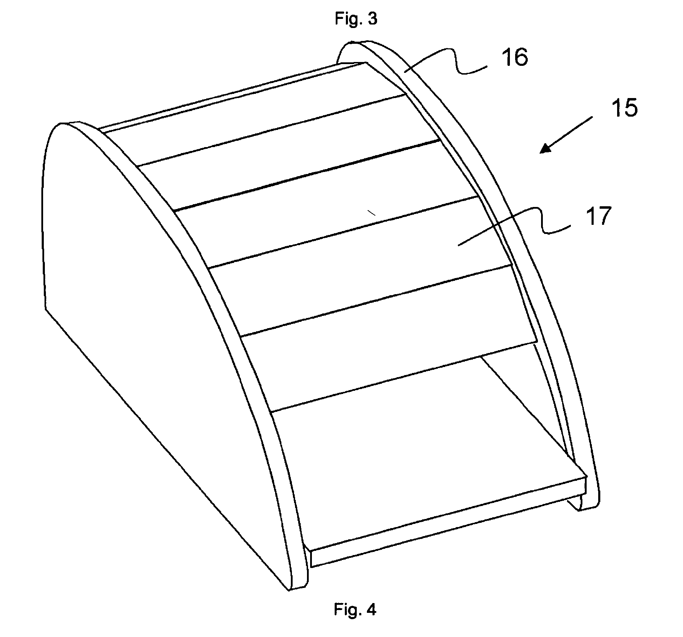

Fig. 3 zeigt eine alternative erfindungsgemäße Mehrschichtplatte bei der das elektromagnetische Wellen abschirmende Gewebe 3 als Gegenzugschicht wirkt und auf eine Seite einer Platte 7 (z.B. Spanplatte) aufgebracht wird. Auf der anderen Seite der Platte 7 ist eine Belagschicht 8 (z.B. Furnierschicht) aufgebracht.

Fig. 4 Zeigt einen Behälter 5 zur Aufbewahrung von Basisstationen mit oder ohne Schnurlostelefone. Die verwendeten Teile 16 (Seitenteile und Boden) bestehen aus Massivholz- und/oder Sperrholzplatten mit einer Zwischenschicht aus elektromagnetische Wellen abschirmenden Gewebe. Zum schließen des Behälters wird eine Art Rollladen 17 verwendet, bei dem die einzelnen Segmente auf ein elektromagnetische Wellen abschirmendes Gewebe aufgeklebt wurden. Insofern stellt jedes einzelne Segment eine erfindungsgemäße Mehrschichtplatte dar und dem Gewebe kommt auch eine mechanische Funktion zu. Als Alternative zum Rollladen kann auch eine Klappe verwendet werden.

## Patentansprüche

1. Mehrschichtplatte (1) mit mindestens einer Holz enthaltenden Schicht (2) wobei mindestens eine Schicht aus einem elektromagnetische Wellen abschirmendem Flächengebilde (3) besteht und das elektromagnetische Wellen abschirmende Flächengebilde zwischen zwei Schichten aus Holz eingebracht ist wobei das elektromagnetische Wellen abschirmende Flächengebilde ein gewebtes oder ungewebtes textiles Flächengebilde ist, das eine die elektrische Leitfähigkeit erhöhende Substanz enthält **dadurch gekennzeichnet, dass** das textile Flächengebilde Metallfasern als die elektrische Leitfähigkeit erhöhende Substanz und Polymerfasern enthält.

2. Mehrschichtplatte nach Anspruch 1 **dadurch gekennzeichnet, dass** das textile Flächengebilde Fasern der Gruppe Polyamidfasern, Polyesterfasern enthält.

3. Mehrschichtplatte nach Anspruch 1 **dadurch gekennzeichnet, dass** die Polymerfasern die die elektrische Leitfähigkeit erhöhende Substanz enthalten.

4. Mehrschichtplatte nach Anspruch 1 **dadurch gekennzeichnet, dass** die Metallfasern aus der Gruppe Stahlfasern, Edelstahlfasern, Aluminiumfasern gewählt sind.

5. Mehrschichtplatte nach Anspruch 1 **dadurch gekennzeichnet, dass** die Metallfasern eine Länge von mindestens 2 cm haben.

6. Mehrschichtplatte nach Anspruch 1 **dadurch gekennzeichnet, dass** der Anteil der Metallfasern an der Masse des elektromagnetische Wellen abschirmenden Flächengebildes mehr als 5% ist.

7. Möbelstück enthaltend mindestens ein Teil aus einer Mehrschichtplatte nach Anspruch 1

8. Möbelstück nach Anspruch 7 **dadurch gekennzeichnet, dass** es sich um einen Behälter zum Aufbewahren eines Telefons, insbesondere einer Basisstation, handelt.

9. Möbelstück nach Anspruch 7 **dadurch gekennzeichnet, dass** es sich um ein Bett handelt.

## Claims

1. A multi-layered board (1), comprising at least one layer (2) containing wood, with at least one layer consisting of a planar structure (3) screening electromagnetic waves and the planar structure screening the electromagnetic waves being introduced between two layers made of wood, with the planar structure screening electromagnetic waves being a woven or non-woven textile planar structure which contains a substance increasing electric conductivity, **characterized in that** the textile planar structure contains metal fibers as the substance increasing electric conductivity and polymer fibers.

2. A multi-layered board according to claim 1, **characterized in that** the textile planar structure comprises fibers of the group of polyamide fibers, polyester fibers.

3. A multi-layered board according to claim 1, **characterized in that** the polymer fibers contain the substance increasing electric conductivity.

4. A multi-layered board according to claim 1, **characterized in that** the metal fibers are chosen from the group of steel fibers, special steel fibers, aluminum fibers.

5. A multi-layered board according to claim 1, **characterized in that** the metal fibers have a length of at least 2 cm.

6. A multi-layered board according to claim 1, **characterized in that** the percentage of metal fibers in the mass of the planar structure screening electromagnetic waves is more than 5%.

7. An item of furniture, containing at least a part of a multi-layered board according to claim 1.

8. An item of furniture according to claim 7, **characterized in that** it concerns a container for storing a phone, especially a base station.

9. An item of furniture according to claim 7, **characterized in that** it concerns a bed.

## Revendications

1. Panneau multicouches (1) avec au moins une couche contenant du bois (2), dans lequel au moins une couche se compose d'une structure de surface arrêtant les ondes électromagnétiques (3) et la structure de surface arrêtant les ondes électromagnétiques est placée entre deux couches de bois, la structure de surface arrêtant les ondes électromagnétiques étant une structure de surface textile tissée ou non tissée qui contient une substance augmentant la conductivité électrique, **caractérisé en ce que** la structure de surface textile contient des fibres métalliques qui constituent la substance augmentant la conductivité électrique et des fibres de polymères.

2. Panneau multicouches selon la revendication 1, **caractérisé en ce que** la structure de surface textile contient des fibres appartenant au groupe des fibres de polyamide et fibres de polyester.

3. Panneau multicouches selon la revendication 1, **caractérisé en ce que** les fibres de polymères contiennent la substance augmentant la conductivité électrique.

4. Panneau multicouches selon la revendication 1, **caractérisé en ce que** les fibres métalliques sont choisies dans le groupe comprenant les fibres d'acier, les fibres d'acier inoxydable, les fibres d'aluminium.

5. Panneau multicouches selon la revendication 1, **caractérisé en ce que** les fibres métalliques ont une longueur d'au moins 2 cm.

6. Panneau multicouches selon la revendication 1, **caractérisé en ce que** la proportion des fibres métalliques dans la masse de la structure de surface arrêtant les ondes électromagnétiques est supérieure à 5 %.

7. Meuble contenant au moins une partie d'un panneau multicouches selon la revendication 1.

8. Meuble selon la revendication 7, **caractérisé en ce qu'**il s'agit d'un conteneur pour le rangement d'un téléphone, en particulier d'une station de base.

9. Meuble selon la revendication 7, **caractérisé en ce qu'**il s'agit d'un lit.
